# DEMANDE DE BREVET EUROPEEN

(11) **EP 1 724 814 A2**
(43) Date de publication de la demande: **22.11.2006**
(21) Numéro de dépôt: 06290775.3
(22) Date de dépôt: 12.05.2006
(51) Int. Cl.: H01L 21/02

(54) **Condensateur intégré à tension de claquage élevée**

(30) Priorité: 18.05.2005 FR 0504988
(71) Demandeur: STMicroelectronics ( Crolles 2) SAS, 38920 Crolles (FR)
(72) Inventeur: Torres, Joaquin, 38950 St Martin le Vinoux (FR); Farcy, Alexis, 73490 La Rivoire (FR)
(74) Mandataire: Boire, Philippe Maxime Charles

(57) **Abrégé**

Un condensateur incorporé dans un circuit électronique intégré comprend deux armatures (1, 2) et une série de couches intermédiaires disposées entre les armatures. Les couches intermédiaires sont alternativement isolantes (10-13) et conductrices (21-23), et chaque couche conductrice (21-23) est isolée électriquement du reste du circuit. Un tel condensateur peut présenter une tension de claquage élevée.

## Description

La présente invention concerne un circuit électronique intégré incorporant un condensateur à tension de claquage élevée. Elle concerne aussi un procédé de réalisation d'un tel condensateur.

De nombreux circuits électroniques intégrés incorporent des condensateurs de type MIM, pour Métal-Isolant-Métal. On peut citer par exemple des circuits de mémoire, des circuits analogiques et des circuits fonctionnant à fréquence élevée. Un condensateur MIM comprend une portion isolante de matériau diélectrique intercalée entre deux portions métalliques formant les armatures du condensateur.

Or certains circuits nécessitent des condensateurs ayant des capacités importantes. Pour obtenir une capacité suffisante sans augmenter les dimensions d'un condensateur, le matériau diélectrique de la portion isolante qui est intercalée entre les armatures est sélectionné de façon à posséder une permittivité diélectrique élevée. En particulier, il est connu d'utiliser de l'alumine (Al₂O₃), de l'oxyde de tantale (Ta₂O₅), de l'oxyde de zirconium (ZrO₂), de l'oxyde d'hafnium (HfO₂), ou de l'oxyde de titane et de strontium (SrTiO₃) à la place de la silice (SiO₂) en tant que matériau diélectrique dans un condensateur. Mais, les portions de ces matériaux diélectriques à permittivité élevée qui sont réalisées présentent de nombreux défauts, parce que la mise en oeuvre de ces matériaux est moins bien maîtrisée qu'une utilisation de silice. Les défauts observés comprennent notamment des impuretés du matériau, des inclusions, des défauts cristallins, des microvides et/ou des microfissures. Les condensateurs qui incorporent ces portions de matériau diélectrique présentent alors des tensions de claquage peu élevées qui constituent une limitation à l'utilisation de ces condensateurs. Dans certains cas, ils présentent aussi un courant de fuite important.

La tension de claquage d'un condensateur intégré dans un circuit électronique est souvent une spécification du cahier des charges de ce circuit. Elle est mesurée, d'une façon connue, pour vérifier qu'elle est supérieure à la valeur prescrite dans le cahier des charges. Une telle mesure fait partie des tests qui sont systématiquement pratiqués lors de la fabrication d'un nouveau circuit, et qui sont répétés ultérieurement pour contrôler une qualité de production lors de la fabrication du circuit en série. Usuellement, la tension de claquage requise pour un condensateur intégré du type MIM est de l'ordre de 10 à 15 volts.

Or, les portions de matériau diélectrique à permittivité élevée qui sont introduites dans les condensateurs de type MIM présentent une tenue au champ électrique inférieure à celle des matériaux diélectriques usuels. Typiquement, la tension de claquage d'un condensateur muni d'une portion de matériau diélectrique à permittivité élevée est inférieure à 10 volts. Pour augmenter la tension de claquage d'un tel condensateur, il est connu d'accroître l'épaisseur de la portion de matériau diélectrique qui est intercalée entre les armatures. Mais la capacité du condensateur devient alors trop faible par rapport à la fonction du condensateur dans le circuit.

Un but de la présente invention consiste donc à proposer un nouveau type de condensateurs intégrés, qui combine l'obtention de capacités suffisantes et de tensions de claquage élevées.

Pour cela, l'invention propose un circuit électronique intégré qui incorpore un condensateur, le condensateur comprenant :
- deux armatures conductrices sensiblement parallèles, et
- une série de couches intermédiaires disposées entre et parallèlement aux armatures, comprenant au moins une couche conductrice et des couches isolantes électriquement, chaque couche conductrice étant intercalée entre deux couches isolantes.

En outre, chaque couche conductrice intermédiaire est isolée électriquement, de sorte qu'elle présente un potentiel électrique flottant lors d'un fonctionnement du circuit.

L'espace inter-armatures d'un condensateur selon l'invention est donc divisé en plusieurs parties, selon la direction perpendiculaire aux armatures, qui correspondent aux couches isolantes intermédiaires. Deux couches isolantes différentes sont séparées par une couche conductrice intermédiaire, dont le potentiel électrique est laissé flottant. Ce potentiel électrique s'établit donc à une valeur variable, qui dépend de la tension électrique appliquée entre les armatures. Chaque couche isolante intermédiaire est soumise à une différence de potentiel électrique, entre les deux faces de cette couche parallèles aux armatures du condensateur, qui est égale à une fraction de la tension électrique existant entre les deux armatures. La tension électrique entre les deux armatures peut alors être supérieure à la tension de claquage de chaque couche isolante intermédiaire, qui serait mesurée entre les deux couches conductrices intermédiaires situées de part et d'autre contre cette couche isolante. En particulier, la différence de potentiel entre les deux faces de chaque couche isolante peut ne pas atteindre la valeur de claquage pour cette couche, alors que la tension électrique totale mesurée entre les deux armatures du condensateur est élevée. Ainsi, la tension de claquage apparente de l'ensemble du condensateur, qui est mesurée entre les deux armatures, est augmentée. En particulier, un condensateur selon l'invention peut présenter une tension de claquage mesurée entre ses deux armatures qui supérieure à 5 volts, voire supérieure à 10 volts.

En outre, chaque couche isolante intermédiaire peut être constituée d'un matériau diélectrique qui présente une permittivité diélectrique élevée. En particulier, l'une au moins des couches isolantes peut comprendre une portion d'un matériau ayant une permittivité diélectrique relative supérieure ou égale à six. Ce matériau peut être l'alumine, l'oxyde de tantale, l'oxyde de zirconium, l'oxyde d'hafnium ou l'oxyde de titane et de strontium, par exemple.

Préférentiellement, les surfaces de chaque couche conductrice intermédiaire qui sont situées contre des couches isolantes sont constituées d'un matériau qui possède une conductivité électrique de type métallique. Dans ce cas, du fait des structures électroniques respectives des couches métalliques et des couches isolantes, la tension de claquage de chaque couche isolante peut être augmentée en choisissant de façon appropriée le matériau à conductivité métallique. En particulier, chaque couche conductrice intermédiaire du condensateur peut être en cuivre (Cu), en aluminium (Al), en platine (Pt), en ruthénium (Ru) ou en nitrure de titane (TiN), par exemple. Le condensateur obtenu est alors du type MIM.

La série de couches intermédiaires peut comprendre au moins trois couches conductrices. La tension de claquage du condensateur peut alors être de l'ordre de trois fois la tension de claquage de chaque couche isolante intermédiaire prise individuellement, notamment lorsque les couches isolantes intermédiaires sont identiques.

En outre, chaque couche isolante intermédiaire a préférablement une épaisseur inférieure à 10 nanomètres, selon la direction perpendiculaire aux armatures du condensateur. En effet, en utilisant les outils de formation de couches qui sont actuellement disponibles commercialement, une couche isolante présente une quantité de défauts susceptibles d'être à l'origine d'un claquage qui augmente avec l'épaisseur de cette couche. Une limitation à 10 nanomètres de l'épaisseur de chaque couche isolante contribue donc à obtenir une tension élevée de claquage du condensateur, mesurée entre les deux armatures.

L'invention propose en outre un procédé de réalisation d'un condensateur dans un circuit électronique intégré, du type décrit ci-dessus. Un tel procédé comprend les étapes suivantes :
/a/ former une couche d'armature inférieure sur le circuit ;
/b/ déposer successivement, au dessus de la couche d'armature inférieure, une série de couches intermédiaires alternativement isolantes et conductrices électriquement, ladite série commençant et se terminant par des couches isolantes ; et
/c/ former une couche d'armature supérieure au dessus de la série de couches intermédiaires.

En outre, le circuit est réalisé de sorte que chaque couche conductrice intermédiaire est isolée électriquement.

Selon un premier mode de mise en oeuvre de l'invention, le procédé comprend en outre l'étape suivante, effectuée après l'étape /c/ :
/d/ graver successivement la couche d'armature supérieure, chaque couche intermédiaire et éventuellement la couche d'armature inférieure en dehors d'une zone du circuit correspondant au condensateur.

Selon un second mode de mise en oeuvre de l'invention, le procédé comprend en outre une étape préliminaire de formation d'une cavité dans le circuit. La couche d'armature inférieure, les couches intermédiaires et la couche d'armature supérieure sont alors successivement formées dans la cavité, de façon conforme sur un fond et des côtés latéraux de celle-ci. Eventuellement, un tel procédé peut aussi comprendre l'étape suivante, effectuée après l'étape /c/ :
/d/ polir le circuit de façon à retirer des portions respectives de la couche d'armature supérieure, des couches intermédiaires et éventuellement de la couche d'armature inférieure en dehors de la cavité.

Dans ces deux modes de réalisation, le procédé peut comprendre en outre l'étape supplémentaire suivante, effectuée après l'étape /d/ correspondante :
/e/ passiver des bords ou des extrémités des couches conductrices intermédiaires formées à l'étape /d/ de façon à supprimer un éventuel chemin de conduction électrique aboutissant à une au moins des couches conductrices intermédiaires.

Ainsi, un éventuel court-circuit qui serait apparu entre deux couches conductrices intermédiaires du condensateur lors de l'étape /d/ de gravure ou de polissage, selon le mode de mise en oeuvre de l'invention, est supprimé. Une telle étape /e/ garantit notamment que les couches conductrices intermédiaires présenteront un potentiel électrique flottant lors d'un fonctionnement du circuit. L'étape /e/ peut comprendre, notamment, une oxydation des bords ou des extrémités des couches conductrices intermédiaires par mise en contact du circuit avec un fluide oxydant.

D'autres particularités et avantages de la présente invention apparaîtront dans la description ci-après de deux exemples de réalisation non limitatifs, en référence aux dessins annexés, dans lesquels :

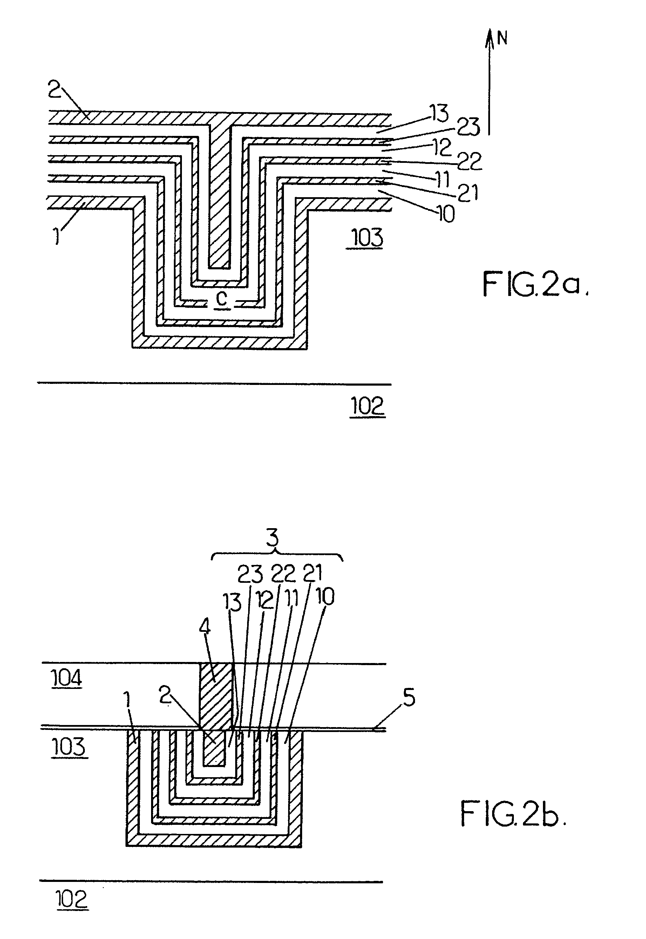

- les figures 1a-1d et 2a-2b illustrent différentes étapes de réalisation d'un circuit électronique intégré à un condensateur, selon deux modes de mise en oeuvre de l'invention.

Pour raison de clarté, les dimensions des éléments représentés sur ces figures ne sont pas en proportion avec leurs dimensions réelles. On désigne par N une direction perpendiculaire à la surface d'un substrat sensiblement plan du circuit. La direction N est orientée vers le haut des figures et les mots «sur», «sous», «inférieur» et «supérieur» utilisés dans la suite le sont en référence à cette orientation. En outre, des références identiques sur des figures différentes désignent des éléments identiques, ou qui ont des fonctions identiques.

Par ailleurs, on se limite à décrire dans la suite une succession d'étapes élémentaires de réalisation du circuit intégré, qui permet de reproduire l'invention. Chaque étape élémentaire, qui est considérée comme connue en soi, n'est pas reprise en détail.

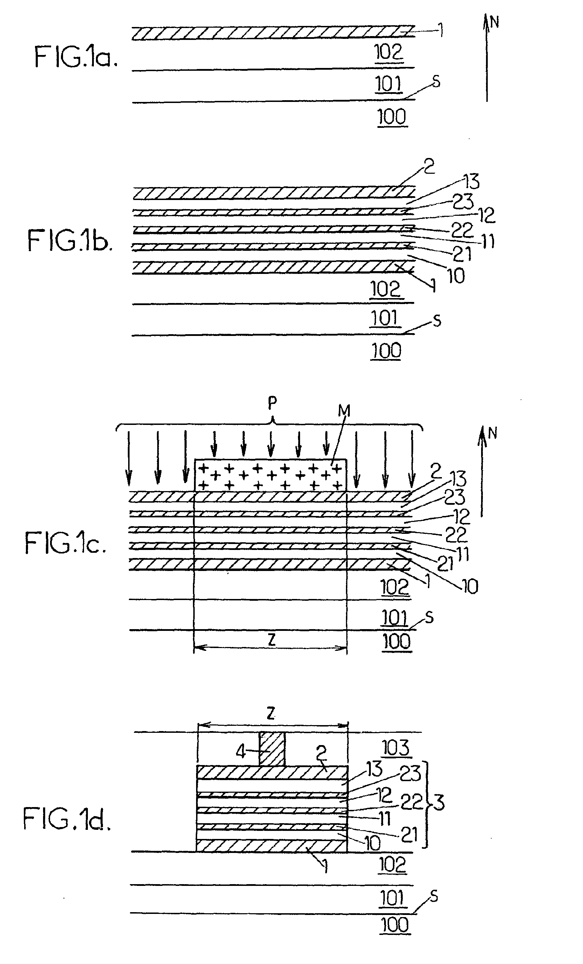

Conformément à la figure 1 a, un substrat 100 de circuit électronique intégré en cours d'élaboration est recouvert sur sa surface supérieure S d'une couche de prémétallisation 101 et d'au moins une couche de métallisation 102. On dépose alors une couche métallique 1 sur la couche 102, en utilisant un procédé connu de l'Homme du métier, tel que le procédé de dépôt par couches atomiques successives, ou ALD (pour «Atomic Layer Deposition» en anglais). La couche 1 peut être en aluminium (AI) et peut avoir une épaisseur de 50 nm (nanomètres) par exemple. Elle peut être réalisée sous forme d'un dépôt dit «pleine plaque» : elle recouvre alors entièrement la surface supérieure du circuit électronique à l'issue du dépôt.

On dépose ensuite successivement des couches 10, 21, 11, 22, 12, 23 et 13 sur la couche 1 (figure 1b). Les couches 10-13 sont en matériau diélectrique, tel que de l'oxyde de tantale (Ta₂O₅), par exemple. Les couches 21-23 sont en matériau métallique, tel que de l'aluminium. Chaque couche 10-13 ou 21-23 possède préférablement une épaisseur comprise entre 5 et 10 nm, selon la direction N. Enfin, une couche métallique 2, qui peut être semblable à la couche 1, est formée sur la dernière couche isolante 13. Les couches 2, 10-13 et 21-23 peuvent recouvrir chacune tout le circuit.

On grave ensuite les couches 2, 21-23, 10-13 et 1, à partir de la surface supérieure du circuit, en dehors d'une zone Z du circuit correspondant aux dimensions du condensateur parallèlement à la surface S du substrat 100. Pour cela, un masque de résine M est formé par lithographie sur le circuit, et un flux de plasma P est accéléré contre la surface supérieure du circuit, parallèlement à la direction N et en sens opposé à celle-ci (figure 1c). Un tel procédé de gravure est bien connu et est désigné par «gravure sèche». La nature des ions contenus dans le plasma de gravure peut être adaptée pour éliminer rapidement les matériaux des différentes couches métalliques ou isolantes. Eventuellement, une couche d'arrêt non représentée, par exemple en nitrure de silicium (Si₃N₄), peut avoir été disposée entre les couches 102 et 1 pour arrêter l'avancement du front de gravure avant de pénétrer dans la couche 102. De cette façon, les couches 2, 13, 23, 12, 22 11, 21, 10 puis 1 sont successivement éliminées en dehors de la zone Z. A l'issue de cette gravure, des portions résiduelles de ces couches subsistent seulement dans la zone Z. Le masque de résine M est alors retiré (figure 1d).

Il est possible que la gravure des couches 1, 2, 10-13 et 21-23 laisse des débris de matériau conducteur sur un bord de l'une des portions résiduelles des couches intermédiaires. A cause des faibles épaisseurs des couches 10-13 et 21-23, de tels débris peuvent provoquer un court-circuit entre deux des portions résiduelles des couches 21-23, ou entre l'une de ces portions de couches 21-23 et la portion résiduelle de l'une des couches 1, 2. Il est alors avantageux d'appliquer un traitement d'oxydation au circuit, pour rendre isolants électriquement les bords découverts des portions résiduelles des couches 21-23. Un tel traitement passive en outre les bords des portions résiduelles des couches 1 et 2, ainsi que la surface supérieure découverte de la portion résiduelle de couche 2.

La réalisation du circuit intégré peut ensuite être poursuivie d'une façon connue. En particulier, une couche de matériau isolant 103 peut être déposée sur le circuit, de façon à recouvrir l'empilement des portions résiduelles des couches 1, 2, 10-13 et 21-23. Une ou plusieurs connexions électriques 4 sont ensuite réalisées au travers de la couche 103, notamment pour connecter la portion résiduelle de couche 2 à d'autres composants électroniques du circuit (non représentés).

Le condensateur obtenu est alors disposé dans la couche 103, qui est une couche dite de métallisation du circuit. Les portions résiduelles des couches 1 et 2 forment respectivement les armatures inférieure et supérieure du condensateur. Dans le cas présent, celles-ci sont planes et parallèles à la surface S du substrat 100. L'espace inter-armatures, référencé 3 sur la figure 1d, est rempli par les portions résiduelles des couches 10-13 et 21-23. Pour cette raison, ces portions résiduelles de couches sont désignées brièvement par «couches intermédiaires» du condensateur. Les couches intermédiaires 10-13, qui sont isolantes, constituent ensemble le diélectrique du condensateur. Celui-ci est donc divisé en plusieurs parties selon la direction N, qui sont séparées par les couches intermédiaires 21-23 qui sont conductrices. Chaque couche intermédiaire isolante 10-13 est donc intercalée entre une armature et une couche intermédiaire conductrice, ou entre deux couches intermédiaires conductrices.

Les inventeurs ont constaté que, contrairement au mode de raisonnement commun, le champ électrique correspondant à la tension de claquage d'une couche isolante unique enserrée entre deux couches conductrices peut devenir supérieur lorsque l'épaisseur de la couche isolante est diminuée. Cette variation inattendue du champ électrique de claquage est attribuée à des défauts du matériau isolant qui sont plus nombreux lorsque la couche est plus épaisse. Les procédés de dépôt actuellement disponibles permettent de former des couches très minces qui ont une faible quantité de défauts. La tension de claquage de la couche isolante, notée V₀, semble alors fixée principalement par les propriétés électroniques du matériau isolant et par celles du matériau de chaque couche conductrice située de part et d'autre de la couche isolante. Selon la découverte des inventeurs, un choix approprié de matériau métallique pour chaque couche conductrice permet d'obtenir une valeur élevée de la tension de claquage V₀ de la couche isolante. La valeur du niveau de Fermi du matériau métallique, lorsqu'elle est comparée aux limites des bandes de valence et/ou de conduction du matériau isolant, semble être un paramètre important pour ce choix.

Chacune des couches isolantes 10-13 est soumise, entre ses deux faces perpendiculaires à la direction N, à une fraction de la tension électrique existant entre les armatures 1 et 2. Cette fraction correspond au rapport entre l'épaisseur de cette couche isolante et la somme des épaisseurs de toutes les couches isolantes 10-13. Un claquage du condensateur, qui se produit par claquage d'une des couches 10-13, intervient donc lorsque la fraction de tension électrique qui est présente entre les faces de cette couche atteint la valeur de claquage pour cette couche. Ainsi, si les couches isolantes intermédiaires 10-13 sont identiques, la tension de claquage du condensateur, mesurée entre les armatures 1 et 2, est sensiblement égale à 4 x V₀. De façon générale, si l'espace inter-armatures 3 contient n couches isolantes identiques et séparées deux à deux par des couches conductrices, n étant un nombre entier, la tension de claquage du condensateur est sensiblement égale à n x V₀. Dans les condensateurs réalisés selon l'invention, V₀ a été mesurée entre 3 et 5 volts. L'invention permet donc de réaliser des condensateurs ayant des tensions de claquage supérieures à 10 volts, voire supérieures à 20 volts environ lorsque n est égal ou supérieur à 3.

Les inventeurs ont en outre constaté que d'éventuels effets de pointes du champ électrique présent dans le condensateur, entre les armatures 1 et 2, sont limités lorsque l'espace inter-armatures 3 est divisé par les couches conductrices. Cette limitation contribue aussi à éviter un claquage du condensateur pour une tension électrique déterminée appliquée entre les armatures 1 et 2.

Les figures 2a et 2b illustrent un second mode de réalisation de l'invention qui est maintenant décrit. On suppose que les couches de métallisation 102 et 103 du circuit électronique intégré ont déjà été réalisées. Une cavité C (figure 2a) est creusée dans la couche 103, à partir de la surface supérieure de celle-ci. De façon connue, les dimensions de la cavité C parallèlement à la surface du substrat 100 peuvent être déterminées par un masque de lithographie. La profondeur de la cavité C, qui peut être de 5 micromètres par exemple, peut être fixée par une durée d'étape de gravure.

Des couches 1, 10, 21, 11, 22, 12, 23, 13 et 2 sont successivement déposées sur le circuit, en utilisant alternativement des matériaux isolants et conducteurs électriquement. Des conditions de dépôt appropriées sont adoptées pour les couches 1, 10-13 et 21-23, afin d'obtenir des dépôts conformes. Autrement dit, les couches obtenues possèdent des faces sensiblement parallèles qui reproduisent la forme de la cavité C : chaque armature et chaque couche intermédiaire du condensateur constitue un revêtement conforme disposé à l'intérieur de la cavité C, et qui s'étend sur le fond et les côtés latéraux de celle-ci. De telles conditions de dépôt sont connues de l'Homme du métier, en particulier pour les procédés de dépôt par couches atomiques successives (ALD) et de dépôt chimique en phase vapeur (CVD pour «Chemical Vapour Deposition» en anglais). A titre d'exemple, la couche 1 peut avoir une épaisseur de 20 nanomètres, les couches 10-13 et 21-23 peuvent avoir chacune une épaisseur comprise entre 5 et 10 nanomètres, et la couche 2 peut avoir une épaisseur suffisante pour combler la cavité C. Lorsque le procédé Damascène est utilisé, les couches 10-13 peuvent être à base de silice (SiO₂) et les couches 21-23 peuvent être en cuivre (Cu).

On effectue ensuite un polissage de la surface supérieure du circuit, de façon à éliminer les parties des couches 1, 2, 10-13 et 21-23 qui sont présentes au dessus de la couche 103 en dehors de la cavité C (figure 2b). Ce polissage peut être effectué en utilisant le procédé CMP (pour «Chemical-Mechanical Polishing» en anglais).

Avantageusement, les extrémités supérieures des portions résiduelles des couches 1, 2, et 21-23, situées au niveau de l'ouverture de la cavité C, sont rendues isolantes électriquement par oxydation. En outre, une couche continue de passivation 5 peut être déposée sur le circuit pour compléter l'isolation de ces extrémités. La couche 5 recouvre notamment les extrémités supérieures découvertes des portions résiduelles des couches 1, 2, 10-13 et 21-23 qui affleurent au niveau de l'ouverture de la cavité C. La couche 5 peut être en oxyde de silicium (SiO₂), en nitrure de silicium (Si₃N₄) ou en carbure de silicium (SiC), par exemple. Son épaisseur peut être de 1 nanomètre, par exemple.

Une couche de métallisation supplémentaire 104 est ensuite déposée sur la couche 5, et une connexion électrique 4 peut être formée au travers des couches 104 et 5 pour connecter l'armature 2 du condensateur à d'autres composants du circuit.

Lorsque le procédé Damascène est utilisé pour réaliser le condensateur, une unique étape lithographique est donc suffisante pour réaliser le condensateur au sein du circuit.

Il est entendu que de nombreuses adaptations peuvent être introduites dans les modes de réalisation d'un circuit à condensateur qui viennent d'être décrits. Parmi celles-ci, on peut citer notamment :
- le nombre de couches conductrices intermédiaires peut être varié pour obtenir une valeur particulière de la tension de claquage du condensateur ;
- chaque couche conductrice du condensateur, intermédiaire ou destinée à former une armature, peut être constituée de plusieurs couches élémentaires. En particulier, un empilement de trois films, constitué d'un film de cuivre disposé entre deux films de nitrure de titane (TiN), peut être utilisé pour constituer chaque couche conductrice intermédiaire ou chaque armature ;
- dans le premier mode de réalisation décrit en relation avec les figures 1a-1d, l'armature inférieure du condensateur peut avoir des dimensions supérieures à celles des couches intermédiaires et de l'armature supérieure, parallèlement à la surface du substrat, notamment pour réduire des effets de bords du champ électrique présent dans le condensateur ;
- le condensateur peut être réalisé dans le substrat du circuit ou dans la première couche de connexions au dessus de la surface du substrat, appelée couche de prémétallisation ; et
- un condensateur conforme au second mode de réalisation de l'invention peut avoir une forme constituée de méandres dans un plan parallèle à la surface du substrat. Le condensateur peut ainsi avoir une capacité importante, sans occuper une portion trop importante de la surface du substrat.

## Revendications

1. Circuit électronique intégré incorporant un condensateur, le condensateur comprenant :
- deux armatures conductrices sensiblement parallèles (1, 2), et
- une série de couches intermédiaires disposées entre et parallèlement aux armatures, comprenant au moins une couche conductrice (21-23) et des couches isolantes électriquement (10-13), chaque couche conductrice étant intercalée entre deux couches isolantes,
dans lequel chaque couche conductrice intermédiaire (21-23) est isolée électriquement, de sorte que ladite couche présente un potentiel électrique flottant lors d'un fonctionnement du circuit, et
le circuit étant **caractérisé en ce que** la série de couches intermédiaires comprend au moins trois couches conductrices (21-23).

2. Circuit selon la revendication 1, dans lequel le condensateur présente une tension de claquage mesurée entre les deux armatures du condensateur (1, 2) supérieure à 5 volts.

3. Circuit selon la revendication 2, dans lequel la tension de claquage mesurée entre les deux armatures du condensateur (1, 2) est supérieure à 10 volts.

4. Circuit selon l'une quelconque des revendications précédentes, dans lequel des surfaces de chaque couche conductrice intermédiaire (21-23) situées contre des couches isolantes (10-13) sont constituées d'un matériau ayant une conductivité électrique de type métallique.

5. Circuit selon l'une quelconque des revendications précédentes, dans lequel chaque couche isolante intermédiaire (10-13) a une épaisseur inférieure à 10 nanomètres, selon une direction (N) perpendiculaire aux armatures du condensateur.

6. Circuit selon l'une quelconque des revendications précédentes, dans lequel l'une au moins des couches isolantes intermédiaires (10-13) comprend une portion d'un matériau ayant une permittivité diélectrique relative supérieure ou égale à six.

7. Circuit selon l'une quelconque des revendications précédentes, dans lequel le condensateur est disposé dans au moins une couche de métallisation (103) ou de prémétallisation (101) du circuit.

8. Circuit selon l'une quelconque des revendications 1 à 7, dans lequel chaque armature du condensateur (1, 2) est sensiblement plane.

9. Circuit selon l'une quelconque des revendications 1 à 7, dans lequel chaque armature (1, 2) et chaque couche intermédiaire (10-13, 21-23) du condensateur constitue un revêtement conforme disposé à l'intérieur d'une cavité (C) dudit circuit, et s'étend sur un fond et plusieurs côtés latéraux de ladite cavité.

10. Procédé de réalisation d'un condensateur dans un circuit électronique intégré, comprenant les étapes suivantes :
/a/ former une couche d'armature inférieure (1) sur le circuit;
/b/ déposer successivement, au dessus de la couche d'armature inférieure (1), une série de couches intermédiaires alternativement isolantes (10-13) et conductrices (21-23) électriquement, ladite série commençant et se terminant par des couches isolantes ; et
/c/ former une couche d'armature supérieure (2) au dessus de la série de couches intermédiaires (10-13, 21-23),
le circuit étant réalisé de sorte que chaque couche conductrice intermédiaire (21-23) est isolée électriquement, et
le procédé étant **caractérisé en ce que** la série de couches intermédiaires comprend au moins trois couches conductrices (21-23).

11. Procédé selon la revendication 10, comprenant en outre l'étape suivante :
/d/ graver successivement la couche d'armature supérieure (2) et chaque couche intermédiaire (10-13, 21-23) en dehors d'une zone du circuit correspondant au condensateur.

12. Procédé selon la revendication 11, comprenant en outre l'étape suivante :
/e/ passiver des bords respectifs des couches conductrices intermédiaires (21-23) formés à l'étape /d/ de façon à supprimer un éventuel chemin de conduction électrique aboutissant à une au moins des couches conductrices intermédiaires.

13. Procédé selon la revendication 10, comprenant en outre une étape préliminaire de formation d'une cavité (C) dans le circuit, et suivant lequel la couche d'armature inférieure (1), les couches intermédiaires (10-13, 21-23) et la couche d'armature supérieure (2) sont successivement formées dans la cavité, de façon conforme sur un fond et des côtés latéraux de ladite cavité.

14. Procédé selon la revendication 13, comprenant en outre l'étape suivante :
/d/ polir le circuit de façon à retirer des portions respectives de la couche d'armature supérieure (2) et des couches intermédiaires (10-13, 21-23) en dehors de la cavité (C).

15. Procédé selon la revendication 14, comprenant en outre l'étape suivante :
/e/ passiver des extrémités des couches conductrices intermédiaires (21-23) formées à l'étape /d/ de façon à supprimer un éventuel chemin de conduction électrique aboutissant à une au moins des couches conductrices intermédiaires.
